# EUROPEAN PATENT SPECIFICATION

(11) **EP 2 290 127 B1**
(45) Date of publication and mention of the grant of the patent: **22.03.2017**
(21) Application number: 10171062.2
(22) Date of filing: 28.07.2010
(51) Int. Cl.: C23C 16/54, C23C 16/455

(54) **Film deposition device**
Filmablagerungsvorrichtung
Dispositif de dépôt de film

(30) Priority: 24.08.2009 JP 2009192892
(43) Date of publication of application: 02.03.2011
(73) Proprietor: FUJIFILM Corporation, Tokyo (JP)
(72) Inventor: Fujinami, Tatsuya, Kanagawa (JP); Takahashi, Shinsuke, Kanagawa (JP); Tonohara, Kouji, Kanagawa (JP); Fujinawa, Jun, Kanagawa (JP)
(74) Representative: Hoffmann Eitle

(56) References cited:
- EP-A1- 1 889 947
- JP-A- 2009 052 063
- JP-B2- 3 101 330
- US-A- 5 520 740
- US-A- 5 968 274
- US-A- 6 153 013
- US-A1- 2004 016 401

## Description

### BACKGROUND OF THE INVENTION

The present invention relates to a film deposition device suitable to produce gas barrier films. The present invention more specifically relates to a film deposition device in which a plurality of treatments including film formation by means of CVD are continuously carried out as an elongated substrate travels, and which can eliminate adverse effects of the pressure in the other treatment rooms and material gases while also suppressing contamination of the device with the material gases used in CVD.

Various functional films (functional sheets) including gas barrier films, protective films, and optical films such as optical filters and antireflection films are used in various devices including optical devices, display devices such as liquid crystal displays and organic EL displays, semiconductor devices, and thin-film solar batteries.

These functional films have been produced by film formation (thin film formation) through vacuum deposition techniques such as sputtering and plasma-enhanced CVD.

Continuous deposition of a film on an elongated substrate is preferred for efficient film formation with high productivity by a vacuum deposition technique.

A typical apparatus known in the art for carrying out such a film formation method is a so-called roll-to-roll film deposition apparatus using a feed roll into which an elongated substrate (a web of substrate) is wound and a take-up roll into which the substrate having a film formed thereon is wound. This roll-to-roll film deposition apparatus continuously forms a film on the elongated substrate in a film deposition room as the substrate travels from the feed roll to the take-up roll on a predetermined path including the film deposition room for depositing a film on the substrate, with the substrate fed from the feed roll in synchronism with the winding of the substrate having the film formed thereon on the take-up roll.

A film formed on a substrate in functional films such as gas barrier films and protective films (i.e., film (layer) for obtaining various functions) is not limited to a monolayer type but a plurality of layers may often be deposited to form a functional film.

For example, functional films may be produced by forming a layer by plasma-enhanced CVD and another layer thereon by sputtering or plasma-enhanced CVD. Instead of the formation of a plurality of layers, there is also a case in which film formation by plasma-enhanced CVD is followed by etching or plasma treatment on the film surface and optionally film formation on the thus treated surface by sputtering or plasma-enhanced CVD.

Such treatments may often be carried out in a vacuum at a predetermined pressure (under reduced pressure). In the roll-to-roll film deposition apparatus, it is not efficient for the substrate to travel in the air and in a vacuum alternately and it is preferred to connect treatment rooms for treatments in a vacuum, and continuously and sequentially carry out each treatment as the substrate travels in a vacuum.

Various treatments in a vacuum are not always carried out at the same pressure. Therefore, when treatment rooms having different treatment pressures are connected to each other, a gas may enter (penetrate into) a lower-pressure room from a higher-pressure room through a communicating portion around the substrate travel path. Such penetration of an unwanted gas may hinder proper treatment or cause contamination of the treatment room.

A known method to solve such a problem involves providing a differential room between adjacent treatment rooms to prevent the upstream-side and downstream-side treatment rooms from adversely affecting each other.

For example, JP 2004-95677 A describes a substrate treatment apparatus which subjects a substrate to film formation by means of CVD or sputtering, and to etching, laser annealing and other treatments, and which includes a drum (pass roll) on which the substrate travels, treatment rooms disposed in a circumferential direction of the drum, and differential rooms (differential evacuation rooms) disposed between the adjacent treatment rooms so that the internal pressure of the differential rooms may be lower than that of the adjacent treatment rooms. US 5 520 740 A is concerned with a process for forming a film by a CVD process. JP 2009 052063 A is concerned with an apparatus for manufacturing a film. JP 3101330 is concerned with a device for forming a deposited film by a microwave plasma CVD method.

EP1889947 A1 discloses an apparatus for depositing a layer on a flexible substrate by CVD.

### SUMMARY OF THE INVENTION

As described in JP 2004-95677 A , in an apparatus which continuously carried out a plurality of treatments on an elongated substrate as it travels, a gas in a treatment room can be prevented from entering its adjacent upstream- and downstream-side treatment rooms by providing differential rooms between the adjacent treatment rooms through which the treatment is continuously carried out and evacuating the differential rooms so that the internal pressure of the differential rooms may be lower than that of the adjacent treatment rooms.

However, in the apparatus which includes the differential rooms between the adjacent treatment rooms so that the pressure of the differential rooms may be lower than that of the treatment rooms, if the treatment rooms include a CVD film forming room, a reactive gas in the CVD film forming room may enter the differential rooms to deposit or form a film therein.

Therefore, maintenance including apparatus cleaning requires much time, thus leading to a decrease in the use efficiency and work efficiency of the device.

In order to solve the aforementioned prior art problems, an object of the present invention is to provide a film deposition device which carries out film deposition in a plurality of treatment rooms including a CVD film forming room as an elongated substrate continuously travels in a longitudinal direction, for example, a device which continuously carries out film deposition in a plurality of treatment rooms facing the peripheral surface of a drum as the substrate travels on the drum, the film deposition device including a differential room
to prevent an adverse effect, that is, contamination with an unwanted gas penetrated into the film deposition room or the treatment room, film deposition due to a reactive gas penetrated into the differential room, and adverse effects on the film formation by means of CVD and other treatments.

In order to achieve the above object, a first aspect of the present invention is defined in claim 1.

The film deposition is preferably performed on the substrate in vacuum as the predetermined treatment in the treatment room.

The film deposition is preferably performed on the substrate by CVD as the predetermined treatment in the treatment room.

In the treatment room as the predetermined treatment, at least one of feed of the substrate from a substrate roll into which the substrate is wound and take-up of the substrate having undergone the film deposition in the CVD film forming room are preferably performed.

Preferably, the film deposition device further comprises one vacuum chamber, and the CVD film forming room, the treatment room and the differential room are disposed in the one vacuum chamber.

The film deposition device includes a drum on an outer peripheral surface of which the substrate travels, and at least one of the CVD film forming room, the treatment room and the differential room forms a room with the outer peripheral surface of the drum.

Each of the CVD film forming room, the treatment room and the differential room forms a room with the outer peripheral surface of the drum.

The control means preferably keeps the differential room at a higher pressure by at least 5 Pa than one of the CVD film forming room and the treatment room which has a higher pressure than the other.

The CVD film forming room preferably has a function of depositing a gas barrier film by plasma-enhanced CVD.

The inventive film deposition device having been configured as above carries out film deposition in a plurality of treatment rooms including a CVD film forming room as an elongated substrate continuously travels in a longitudinal direction and includes a differential room between adjacent treatment rooms to prevent an unwanted gas to enter (penetrate into) the CVD film forming room or treatment room to adversely affect the treatment or cause contamination.

The pressure of the differential room is set higher than that of the adjacent rooms, thus preventing penetration of a reactive gas for use in CVD into the differential room and also film deposition in the differential room and its contamination. In addition, a gas to be supplied to both the adjacent treatment rooms or an inert gas is supplied to the differential room so that the differential room may have a higher pressure than that of the adjacent rooms, and therefore there is no adverse effect on the CVD film formation or the treatment in the treatment rooms.

### BRIEF DESCRIPTION OF THE DRAWINGS

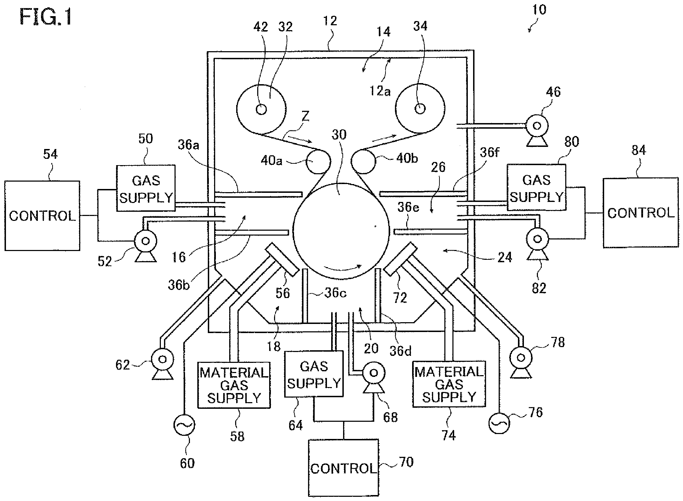

FIG. 1 is a schematic view showing an embodiment of a film deposition device of the present invention.

### DETAILED DESCRIPTION OF THE INVENTION

Next, the film deposition device of the present invention is described in detail by referring to the preferred embodiments shown in the accompanying drawing.

FIG. 1 is a schematic view showing an embodiment of a film deposition device of the present invention.

A film deposition device 10 shown in FIG. 1 is a device capable of deposition of a two-layer film on a substrate Z by plasma-enhanced CVD, and includes a vacuum chamber 12 as well as a feed and take-up room 14, a first differential room 16, a first film deposition room 18, a second differential room 20, a second film deposition room 24, a third differential room 26 and a drum 30 formed in the vacuum chamber 12.

In the present invention, the substrate Z is not particularly limited but elongated films (sheets) capable of CVD film formation as exemplified by resin films such as polyethylene terephthalate (PET) films and metallic films are all available.

The substrate used may be a film obtained by forming layers (films) for exhibiting various functions (e.g., planarizing layer, protective layer, adhesion layer, light-reflecting layer, antireflection layer) on a resin film serving as a base.

In the film deposition device 10, the substrate Z in a web form is fed from a substrate roll 32 of the feed and take-up room 14, travels on the drum 30 in a longitudinal direction and is subjected to sequential film deposition in the first film deposition room 18 and the second film deposition room 24 before being rewound on a take-up shaft 34 in the feed and take-up room 14 (rewound into a roll).

The drum 30 is a cylindrical member which rotates counterclockwise around the central axis in FIG. 1.

The drum 30 causes the substrate Z guided by a guide roller 40a of the feed and take-up room 14 to be described below along a predetermined path and held at a predetermined position in a predetermined region of the outer peripheral surface to travel in the longitudinal direction and sequentially pass through the first differential room 16, the first film deposition room 18, the second differential room 20, the second film deposition room 24 and the third differential room 26 to reach a guide roller 40b of the feed and take-up room 14.

The drum 30 also serves as a counter electrode of a shower head electrode 56 in the first film deposition room 18 and a shower head electrode 72 in the second film deposition room 24 to be described later and forms an electrode pair with the shower head electrode 56 and an electrode pair with the shower head electrode 72.

To this end, the drum 30 is connected to a bias power source or grounded (connection is not shown in both the cases). Alternatively, the drum 30 may be capable of switching between connection to the bias power source and grounding.

The drum 30 may serve as a means for adjusting the temperature of the substrate Z during the film deposition in the first film deposition room 18 and the second film deposition room 24. Therefore, the temperature adjusting means is preferably built into the drum 30. The temperature adjusting means of the drum 30 is not particularly limited and various types of temperature adjusting means including one in which a refrigerant is circulated and a cooling means using a Peltier element are all available.

The feed and take-up room 14 is defined by an inner wall 12a of the vacuum chamber 12, the outer peripheral surface of the drum 30, and partition walls 36a and 36f extending from the inner wall 12a to the vicinity of the outer peripheral surface of the drum 30.

The ends of the partition walls 36a and 36f opposite from the inner wall of the vacuum chamber 12 approach the outer peripheral surface of the drum 30 till the position where the ends do not come in contact with the substrate Z in a stationary state to separate the feed and take-up room 14 from the first differential room 16 and the third differential room 26 in a substantially air-tight manner. The other partition walls also have the same function in this regard.

The feed and take-up room 14 includes the take-up shaft 34, the guide rollers 40a and 40b, a rotary shaft 42 and a vacuum evacuation means 46.

The guide rollers 40a and 40b are of an ordinary type guiding the substrate Z on a predetermined travel path. The take-up shaft 34 is of a known type for elongated sheets which winds up the substrate Z after the film deposition.

In the illustrated case, the substrate roll 32 into which the substrate Z in an elongated shape is wound is mounted on the rotary shaft 42. Upon mounting of the substrate roll 32 on the rotary shaft 42, the substrate Z is passed along a predetermined path including the guide roller 40a, the drum 30 and the guide roller 40b to reach the take-up shaft 34.

In the film deposition device 10, the substrate Z is fed from the substrate roll 32 in synchronism with the winding of the substrate Z having a film formed thereon on the take-up shaft 34 to sequentially carry out film deposition in the first film deposition room 18 and the second film deposition room 24 as the substrate Z in an elongated shape travels on the predetermined travel path in the longitudinal direction. Therefore, the feed and take-up room 14 is the most upstream room and also the most downstream room in the direction of travel of the substrate Z in the film deposition device 10.

The vacuum evacuation means 46 evacuates the feed and take-up room 14 to reduce its pressure in accordance with the pressure of the first film deposition room 18 and the second film deposition room 24 (film deposition pressure) to prevent the pressure in the feed and take-up room 14 from which the substrate Z is fed and where the substrate Z is wound up, from adversely affecting the film deposition in the first film deposition room 18 and the second film deposition room 24.

In the present invention, the vacuum evacuation means 46 is not particularly limited, and exemplary means that may be used include vacuum pumps such as a turbo pump, a mechanical booster pump, a rotary pump and a dry pump, an assist means such as a cryogenic coil, and various other known (vacuum) evacuation means which use a means for adjusting the ultimate degree of vacuum or the amount of air discharged and are employed in vacuum deposition devices.

In this regard, the same holds true for the other vacuum evacuation means.

The first differential room 16 is provided downstream of the feed and take-up room 14 in the direction of travel of the substrate Z.

The first differential room 16 is defined by the inner wall 12a, the outer peripheral surface of the drum 30, and partition walls 36a and 36b extending from the inner wall 12a to the vicinity of the outer peripheral surface of the drum 30. The first differential room 16 includes a gas supply means 50, a vacuum evacuation means 52 and a control means 54.

The vacuum evacuation means 52 evacuates the first differential room 16. The gas supply means 50 is of a known type used in vacuum deposition devices such as plasma CVD devices to supply a predetermined gas to the first differential room 16.

In the present invention, the gas supply means for supplying a gas to the differential room (means for introducing a gas to the differential room) supplies to the differential room a gas to be supplied to both of the adjacent CVD device and treatment room, and/or an inert gas.

In the illustrated case, the treatment room adjacent to the first differential room 16 is the feed and take-up room 14 where the substrate Z is fed from the substrate roll 32 and the substrate Z having a film formed thereon is wound up, and no gas is basically introduced therein. Therefore, the gas supply means 50 supplies inert gases such as nitrogen gas, argon gas and helium gas to the first differential room 16.

The control means 54 controls the evacuation made by the vacuum evacuation means 52 and the amount of gas supplied from the gas supply means 50 so that the internal pressure of the first differential room 16 may be higher than that of the adjacent treatment rooms including the feed and take-up room 14 and the first film deposition room 18 (or one of the feed and take-up room 14 and the first film deposition room 18 which has a higher pressure than the other).

This point will be described later in further detail.

The first film deposition room 18 is provided downstream of the first differential room 16.

The first film deposition room 18 is defined by the inner wall 12a, the outer peripheral surface of the drum 30, and partition walls 36b and 36c extending from the inner wall 12a to the vicinity of the outer peripheral surface of the drum 30.

In the film deposition device 10, the first film deposition room 18 carries out film deposition by capacitively coupled plasma-enhanced CVD (hereinafter abbreviated as "CCP-CVD") on the surface of the substrate Z and includes the shower head electrode 56, a material gas supply means 58, an RF power source 60, and a vacuum evacuation means 62.

The shower head electrode 56 is of a known type used in CCP-CVD.

In the illustrated case, the shower head electrode 56 is, for example, in the form of a hollow rectangular solid and is disposed so that its largest surface faces the outer peripheral surface of the drum 30. A large number of through holes are formed at the whole surface of the shower head electrode 56 facing the drum 30. The surface of the shower head electrode 56 facing the drum 30 may be curved so as to follow the outer peripheral surface of the drum 30.

In the illustrated embodiment, one shower head electrode (film deposition means using CCP-CVD) is provided in the first film deposition room 18. However, this is not the sole case of the present invention and a plurality of shower head electrodes may be disposed in the direction of travel of the substrate Z. In this regard, the same holds true when using plasma-enhanced CVD of other type than CCP-CVD. For example, when an inorganic layer is formed by ICP-CVD, a plurality of coils for forming an induced electric field (induced magnetic field) may be provided along the direction of travel of the substrate Z.

The present invention is not limited to the case in which the shower head electrode 56 is used, and a common electrode in plate form and a material gas supply nozzle may be used.

The material gas supply means 58 is of a known type used in vacuum deposition devices such as plasma CVD devices, and supplies a gas material into the shower head electrode 56.

As described above, a large number of through holes are formed at the surface of the shower head electrode 56 facing the drum 30. Therefore, the material gas supplied into the shower head electrode 56 passes through the through holes to be introduced into the space between the shower head electrode 56 and the drum 30.

The RF power source 60 is one for supplying plasma excitation power to the shower head electrode 56. Known RF power sources used in various plasma CVD devices can be all used for the RF power source 60.

In addition, the vacuum evacuation means 62 evacuates the first film deposition room 18 to keep it at a predetermined film deposition pressure in order to form a film by plasma-enhanced CVD.

In the present invention, the method of depositing a film in the CVD film forming room is not limited to the illustrated CCP-CVD and known CVD techniques including plasma-enhanced CVD such as inductively coupled plasma-enhanced CVD (ICP-CVD) and microwave plasma CVD, catalytic CVD (Cat-CVD) and thermal CVD.

The film deposited in the CVD film forming room of the film deposition device of the present invention is not particularly limited and films that can be deposited by CVD are all usable. Particularly preferred examples of the film include gas barrier films made of silicon oxide, aluminum oxide and silicon nitride.

In other words, particles generated by delamination of a film deposited or formed in an unwanted area of the device diffuse to adhere to the substrate surface or the film surface, or to penetrate into the film, thus lowering the quality of the film deposited by plasma-enhanced CVD. Such adhesion or penetration of particles is a major cause of a film defect and particularly in the gas barrier film, the film defect is the most major cause of reduced gas barrier properties.

As will be described later in detail, the film deposition device of the present invention can considerably suppress deposition and formation of a film in an unwanted area of the device. Therefore, the present invention is employed with particular advantage to deposit the gas barrier film because particles due to the delamination of a film deposited in an unwanted area can be prevented from diffusing and a high-quality gas barrier film having no deteriorated gas barrier properties resulting from the particles can be deposited in a consistent manner.

As described above, the film deposition device 10 evacuates the feed and take-up room 14 as well to prevent the pressure of the feed and take-up room 14 from adversely affecting the film deposition pressure of the first film deposition room 18 or the second film deposition room 24.

In the film deposition device 10, the first differential room 16 is provided between the feed and take-up room 14 as the treatment room and the first film deposition room 18 as the CVD film forming room so that the internal pressure of the first differential room 16 may be higher or at a lower degree of vacuum than that of the adjacent feed and take-up room 14 and first film deposition room 18.

As described above, in the apparatus which continuously treat the substrate in the treatment rooms connected to each other as it travels, an unwanted gas was prevented from penetrating into the treatment rooms such as the film deposition room by evacuating the differential rooms provided to prevent the penetration of an unwanted gas from the treatment rooms connected thereto so that the differential rooms may have a lower pressure than the treatment rooms connected thereto.

However, in cases where the treatment rooms include a CVD film forming room, a material gas for use in CVD penetrates into the differential rooms and deposits a film therein, and such a configuration brings about hard maintenance and reduced workability.

In contrast, in the present invention, the differential room has a higher pressure than the adjacent rooms, whereby the gas in the first film deposition room 18 can be prevented from entering or penetrating into the feed and take-up room 14 and the first differential room 16. Therefore, the material gas used for CVD does not enter the feed and take-up room 14 or the first differential room 16 to deposit or form a film therein.

The pressure in the first differential room 16 is set higher than the feed and take-up room 14 and the first film deposition room 18, but the gas supplied to the first differential room 16, that is, the gas entering the feed and take-up room 14 and the first film deposition room 18 through the first differential room 16 includes an inert gas (and/or a gas supplied to both the rooms between which the differential room is disposed) and therefore does not adversely affect the film deposition in the first film deposition room 18, nor are there penetration of impurities into the film being formed, contamination of the interior of the feed and take-up room 14, or adverse effects on the substrate Z within the room.

In other words, in the film deposition device which carries out film deposition in a plurality of treatment rooms including a CVD film forming room as an elongated substrate continuously travels in a longitudinal direction, the present invention can prevent a gas in the CVD film forming room from entering a treatment room and vice versa to adversely affect the treatment or cause contamination, and also prevent penetration of a CVD reactive gas into the differential room, that is, film deposition and contamination of the differential room.

An inert gas and/or a gas to be supplied to both the adjacent treatment rooms is supplied to the differential room and therefore the supplied gas does not adversely affect the CVD film formation or the treatment in the treatment rooms.

The aforementioned effect of the present invention is also achieved between the first film deposition room 18, the second differential room 20, and the second film deposition room 24, and between the second film deposition room 24, the third differential room 26 and the feed and take-up room 14.

There is no particular limitation on the difference between the pressure of the feed and take-up room 14 and the first film deposition room 18 and the pressure of the first differential room 16 disposed therebetween, but the first differential room 16 should have a slightly higher pressure than that of the adjacent rooms.

In other words, the pressure of the first differential room 16 should be appropriately set higher than that of the feed and take-up room 14 and the first film deposition room 18 according to the pressure of the feed and take-up room 14 (treatment room interposing the differential room together with the CVD film forming room) and the first film deposition room 18, the difference between the pressure of the feed and take-up room 14 and that of the first film deposition room 18, and the capacity of the vacuum evacuation means disposed in the feed and take-up room 14 and the first film deposition room 18 so as not to adversely affect the pressure of the feed and take-up room 14 and the first film deposition room 18 and so as to minimize adverse effects if any.

According to the study made by the inventors of the present invention, the pressure of the first differential room 16 (differential room) is preferably set higher by at least 5 Pa than one of the feed and take-up room 14 and the first film deposition room 18 having the higher pressure, because the film deposition pressure in CVD is usually from a few Pa to several hundred Pa.

Such a layout enables the first differential room 16 to separate the feed and take-up room 14 and the first film deposition room 18 from each other while more reliably preventing the gas in the first film deposition room 18 from entering the first differential room 16, and is therefore preferred.

Because the adverse effect of the pressure in the differential room on the pressure in its adjacent rooms can be minimized, the difference between the pressure of the first differential room 16 and that of one of the feed and take-up room 14 and the first film deposition room 18 having the higher pressure is preferably 10 Pa or less.

The same holds true for the second differential room 20 and the third differential room 26.

The second differential room 20 is provided downstream of the first film deposition room 18.

The second differential room 20 is defined by the inner wall 12a, the outer peripheral surface of the drum 30, and partition walls 36c and 36d extending from the inner wall 12a to the vicinity of the outer peripheral surface of the drum 30.

The second differential room 20 includes a gas supply means 64, a vacuum evacuation means 68 and a control means 70. As in the first differential room 16, the vacuum evacuation means 68 evacuates the second differential room 20 and the gas supply means 64 is of a known type supplying a predetermined gas to the second differential room 20.

The gas supply means 64 supplies to the second differential room 20 a material gas to be supplied to the first film deposition room 18 and the second film deposition room 24 and/or an inert gas.

Therefore, the gas supply means 64 may supply to the second differential room 20 not the inert gas but the material gas to be supplied to both the film deposition rooms. More specifically, in cases where the material gas used in the first film deposition room 18 and the second film deposition room 24 is hydrogen gas, not the inert gas but the hydrogen gas may be supplied to the second differential room 20.

The gas supply means 64 may of course supply the inert gas to the second differential room 20. The material gas to be used in the first film deposition room 18 and the second film deposition room 24 and the inert gas may both be supplied to the second differential room 20.

As in the aforementioned control means 54, the control means 70 controls the evacuation made by the vacuum evacuation means 64 and the amount of gas supplied from the gas supply means 64 so that the internal pressure of the second differential room 20 may be higher than that of the first film deposition room 18 and the second film deposition room 24.

The second film deposition room 24 is provided downstream of the second differential room 20.

The second film deposition room 24 is defined by the inner wall 12a, the outer peripheral surface of the drum 30, and partition walls 36d and 36e extending from the inner wall 12a to the vicinity of the outer peripheral surface of the drum 30.

As in the first film deposition room 18, the second film deposition room 24 carries out film deposition by CCP-CVD on the substrate Z or the substrate Z having a film deposited in the first film deposition room 16.

Therefore, the second film deposition room 24 includes the shower head electrode 72, a material gas supply means 74, an RF power source 76 and a vacuum evacuation means 78 which are similar to the shower head electrode 56, the material gas supply means 58, the RF power source 60 and the vacuum evacuation means 62 in the first film deposition room 18.

As in the first film deposition room 18, the layout of the second film deposition room 24 is not limited to this.

As in the first film deposition room 18, the film to be deposited in the second film deposition room 24 is not particularly limited and films capable of formation by means of CVD are all usable.

In the film deposition device 10, the film deposited in the second film deposition room 24 may be the same as or different from the film deposited in the first film deposition room 18. In cases where the same type of film is deposited in the first film deposition room 18 and the second film deposition room 24, both the film deposition rooms may apply the same or different film deposition conditions such as the film deposition pressure, amount of material gas supplied and film deposition rate.

The third differential room 26 is provided downstream of the second film deposition room 24.

The third differential room 26 is defined by the inner wall 12a, the outer peripheral surface of the drum 30, and partition walls 36e and 36f extending from the inner wall 12a to the vicinity of the outer peripheral surface of the drum 30.

The third differential room 26 includes a gas supply means 80, a vacuum evacuation means 82 and a control means 84 which are similar to those in the first differential room 16 and the second differential room 20.

The feed and take-up room 14 is located downstream of the third differential room 26. In other words, the third differential room 26 is disposed between the second film deposition room 24 and the feed and take-up room 14. As described above, the feed and take-up room 14 is evacuated depending on the pressure of the first film deposition room 18 or the second film deposition room 24 but no gas is basically supplied thereto.

Therefore, the gas supply means 80 supplies the inert gas to the third differential room 26 as in the first differential room 16.

As in the aforementioned control means 54, the control means 84 controls the evacuation made by the vacuum evacuation means 82 and the amount of gas supplied from the gas supply means 80 so that the internal pressure of the third differential room 26 may be slightly higher than one of the second film deposition room 24 and the feed and take-up room 14 having the higher pressure.

The operation of the film deposition device 10 is described below.

As described above, upon mounting of the substrate roll 32 on the rotary shaft 42, the substrate Z is let out from the substrate roll 32 and is passed along a predetermined travel path including the guide roller 40a, the drum 30 and the guide roller 40b to reach the take-up shaft 34.

Once the substrate Z has been passed through the travel path, the vacuum chamber 12 is closed and the vacuum evacuation means 46, 52, 62, 68, 78 and 82 are driven to start evacuation of the respective rooms.

Once the feed and take-up room 14, the first differential room 16, the first film deposition room 18, the second differential room 20, the second film deposition room 24 and the third differential room 26 are all evacuated to a predetermined degree of vacuum or less, the gas supply means 50, 64 and 80 are driven to introduce predetermined gases to the respective differential rooms, and the material gas supply means 58 and 74 are driven to supply the material gases to both the film deposition rooms.

As described above, the respective control means adjust the pressure so that the first differential room 16 may have a higher pressure than the feed and take-up room 14 and the first film deposition room 18, the second differential room 20 may have a higher pressure than the first film deposition room 18 and the second film deposition room 24, and the third differential room 26 may have a higher pressure than the second film deposition room 24 and the feed and take-up room 14.

As also described above, the inert gas is supplied to the first differential room 16 and the third differential room 26, and the material gas to be supplied to each of the first film deposition room 18 and the second film deposition room 24 and/or the inert gas is supplied to the second differential room 20.

Once the pressure in all the rooms has stabilized at a predetermined value, the rotation of the drum 30 is started to start traveling of the substrate Z and the RF power sources 60 and 76 are driven to start film deposition on the substrate Z in the film deposition room 18 and the second film deposition room 24 as the substrate Z travels in the longitudinal direction.

As described above, according to the present invention, the differential rooms are provided between the feed and take-up room 14 and its adjacent film deposition room and between the adjacent film deposition rooms, and an inert gas or the same gas as in the film deposition rooms is introduced so that the differential rooms may have a higher pressure than the adjacent rooms.

Therefore, the gases in the film deposition rooms do not enter the feed and take-up room 14 to enable contamination of the feed and take-up room 14 and contamination of the substrate Z before and after the film deposition to be prevented. The gases in the film deposition rooms also do not enter the differential rooms to enable contamination of the differential rooms and deposition and formation of a film to be further prevented. The gas supplied to the differential rooms is an inert gas or a gas to be supplied to both the adjacent treatment rooms and therefore do not adversely affect the film deposition.

As is clear from the above, the feed and take-up room 14 and the second film deposition room 24 in the illustrated film deposition device 10 serve as the treatment rooms in the present invention in cases where the first film deposition room 18 is used as the CVD film forming room in the present invention. On the other hand, in cases where the second film deposition room 24 is used as the CVD film forming room of the present invention, the first film deposition room 18 and the feed and take-up room 14 serve as the treatment rooms in the present invention.

In other words, the illustrated film deposition device 10 can also be deemed to include in total three film deposition devices of the present invention which includes a film deposition device having the feed and take-up room 14, the first differential room 16 and the first film deposition room 18, a film deposition device having the first film deposition room 18, the second differential room 20 and the second film deposition room 24, and a film deposition device having the second film deposition room 24, the third differential room 26 and the feed and take-up room 14.

The film deposition device of the present invention is not limited to this type and may be of a type only including a CVD film forming room, a differential room and a treatment room. Alternatively, the film deposition device of the present invention may be of a type including two or at least four film deposition devices of the present invention.

The illustrated film deposition device 10 uses the feed and take-up room 14 where feed of the substrate Z to be treated and take-up of the substrate Z having undergone the film deposition are both performed. However, this is not the sole case of the present invention and the film deposition device 10 may be configured such that a feed room (first treatment room) for feeding the substrate Z from the substrate roll and a take-up room (second treatment room) for winding the substrate Z having undergone the film deposition are provided as separate entities.

In other words, the film deposition device of the present invention may include at least one CVD film forming room, a feed room, a take-up room, and differential rooms disposed between the CVD film forming room and the feed room, and between the CVD film forming room and the take-up room, respectively. In cases where the film deposition device of the present invention includes a plurality of CVD film forming rooms, the film deposition device also includes other differential room(s) disposed between adjacent two CVD film forming rooms. In cases where the film deposition device of the present invention also has at least one film deposition treatment room where vacuum deposition is performed, the film deposition device further includes another differential room disposed between the CVD film forming room and the film deposition treatment room.

In the illustrated film deposition device 10, the feed and take-up room 14, the first differential room 16, the first film deposition room 18, the second differential room 20, the second film deposition room 24 and the third differential room 26 are sequentially disposed around the periphery of the drum 30. However, the present invention is not limited to this and may be configured such that the feed and take-up room 14 is divided into the feed room and the take-up room, and the feed room, the first differential room 16, the first film deposition room 18, the second differential room 20, the second film deposition room 24, the third differential room 26 and the take-up room are sequentially disposed in line from the upstream side of the travel path of the substrate.

The feed room for feeding the substrate Z from the substrate roll may be separated from the take-up room for winding up the substrate Z after the film deposition.

The treatment room in the present invention is not limited to one where film formation by means of plasma-enhanced CVD or feed/take-up of the substrate is carried out, and various rooms for carrying out various treatments on the substrate as exemplified by a treatment room for film deposition by sputtering or vacuum evaporation and a treatment room for plasma treatment or etching can be employed as long as the treatment room includes a vacuum evacuation means.

While the film deposition device of the present invention has been described above in detail, the present invention is by no means limited to the foregoing embodiment and it should be understood that various improvements and modifications are possible without departing from the scope and spirit of the present invention.

### EXAMPLES

Next, the present invention is described in further detail by referring to the Examples.

### Example 1

The film deposition device 10 shown in PIG. 1 was used to deposit a silicon nitride film on a substrate Z.

The substrate Z used was a PET film (Cosmoshine A4300 available from Toyobo Co., Ltd.).

Silane gas (at a flow rate of 100 sccm), ammonia gas (at a flow rate of 100 sccm) and nitrogen gas (at a flow rate of 800 sccm) were used as the material gases to form the silicon nitride film by means of CCP-CVD. The gas used to supply to the differential rooms was nitrogen gas (at a flow rate of 1000 sccm).

The film deposition pressure of the first film deposition room 18 and the second film deposition room 24 was set to 30 Pa and 20 Pa, respectively, and the first differential room 16 and the second differential room 20 were set to a pressure of 35 Pa, whereas the third differential room 26 was set to a pressure of 25 Pa.

In addition, the power sources used were RF power sources at a frequency of 13.56 MHz and the plasma excitation power supplied to the shower head electrodes was 1 kW.

In the film deposition device 10, a silicon nitride film was deposited on the substrate Z with a length of 1000 m under the foregoing conditions and the interior of the three differential rooms was visually checked. As a result, film deposition was not confirmed at all in all of the differential rooms and rated good in the evaluation item to be referred to later.

### Examples 2 and 3 and Comparative Example 1

In Example 2, Example 1 was repeated except that argon gas was introduced into the differential rooms to form a silicon nitride film on the substrate Z with a length of 1000 m, and the interior of the three differential rooms was visually checked and evaluated.

In Example 3, Example 1 was repeated except that the amount of evacuation of each differential room by means of the vacuum evacuation means was regulated to adjust the pressure of the first differential room 16 and the second differential room 20 to 32 Pa, and the third differential room 26 to 22 Pa to form a silicon nitride film on the substrate Z with a length of 1000 m, and the interior of the three differential rooms was visually checked and evaluated.

In Comparative Example 1, Example 1 was repeated except that the amount of evacuation of each differential room by means of the vacuum evacuation means was regulated to adjust the pressure of all of the first differential room 16, the second differential room 20 and the third differential room 26 to 10 Pa to form a silicon nitride film on the substrate Z with a length of 1000 m, and the interior of the three differential rooms was visually checked and evaluated.

A case in which film deposition was not confirmed at all in all of the differential rooms was rated good.

A case in which slight film deposition was confirmed in at least one of the differential rooms was rated fair.

A case in which a large amount of film deposition was confirmed in at least one of the differential rooms was rated poor.

The pressure of the respective rooms and the evaluation results are shown in Table 1 together with those of Example 1.

**Table 1**

| | Pressure | | | Gas supplied to differential unit | Evaluation |
|---|---|---|---|---|---|
| | First differential unit | Second differential unit | Third differential unit | | |
| Example 1 | 35 | 35 | 25 | Nitrogen gas | Good |
| Example 2 | 35 | 35 | 25 | Argon gas | Good |
| Example 3 | 32 | 32 | 22 | Nitrogen gas | Fair |
| Comparative Example 1 | 10 | 10 | 10 | Nitrogen gas | Poor |

| | | | | | |
|---|---|---|---|---|---|
| In all the examples, the first film deposition unit, the second< film deposition unit, and the feed and take-up unit were set to a pressure of 30 Pa, 20 Pa and 15 Pa, respectively. | | | | | |

As shown in Table 1, the present invention is capable of considerably improving the workability and the ease of maintenance of the film deposition device while considerably reducing film deposition in the differential room.

The above results clearly show the beneficial effects of the present invention.

The present invention can considerably improve the ease of maintenance and the workability of the film deposition device and be therefore advantageously used to produce gas barrier films.

## Claims

1. A film deposition device (10) in which film deposition is performed on an elongated substrate (Z) which is traveling in a longitudinal direction, the film deposition device (10) comprising:
a CVD film forming room (18) disposed on a travel path of said substrate (Z), including a material gas supply means (58) and a first evacuation means (62) and having a function of performing the film deposition on said substrate (Z) by CVD;
a treatment room (14, 24) disposed upstream or downstream of said CVD film forming room (18) on the travel path, including a second evacuation means (46, 78) and having a function of performing a predetermined treatment on said substrate (Z);
a differential room (16, 20) disposed between and communicating with said CVD film forming room (18) and said treatment room (14, 24) on said travel path;
and a drum (30) on an outer peripheral surface of which said substrate (Z) travels, and wherein said CVD film forming room (18, 24), said film deposition treatment room (18, 24) and said differential room (16, 20, 26) form a room with the outer peripheral surface of said drum (30),
wherein said drum (30) serves as a counter electrode of a shower head electrode (56) in said CVD film forming room (18),
wherein said differential room (16, 20) includes a third evacuation means (52, 68), a gas introducing means (50, 64) for introducing at least one of a gas to be supplied to both of said CVD film forming room (18) and said treatment room (14, 24), and an inert gas, wherein said differential room (16, 20) includes a control means (54, 70) which controls said third evacuation means (52, 68) and said gas introducing means (50, 64) to keep said differential room (16, 20) at a higher pressure than said CVD film forming room (18) and said treatment room (14, 24).

2. The film deposition device according to claim 1, wherein the film deposition is performed on said substrate (Z) in vacuum as said predetermined treatment in said treatment room (24).

3. The film deposition device according to claim 2, wherein the film deposition is performed on said substrate (Z) by CVD as said predetermined treatment in said treatment room (24).

4. The film deposition device according to any one of claim 1 to 3, wherein, in said treatment room (14) as said predetermined treatment, at least one of feed of said substrate (Z) from a substrate roll (32) into which said substrate (Z) is wound and take-up of said substrate (Z) having undergone the film deposition in said CVD film forming room (18) are performed.

5. The film deposition device according to any one of claims 1 to 4, further comprising one vacuum chamber (12),
wherein said CVD film forming room (18), said treatment room (14, 24) and said differential room (16, 20) are disposed in said one vacuum chamber (12).

6. The film deposition device according to any one of claims 1 to 5, wherein said film deposition device (10) includes a drum (30) on an outer peripheral surface of which said substrate (Z) travels, and wherein at least one of said CVD film forming room (18), said treatment room (14, 24) and said differential room (16, 20) forms a room with the outer peripheral surface of said drum (30).

7. The film deposition device according to claim 6, wherein each of said CVD film forming room (18), said treatment room (14, 24) and said differential room (16, 20) forms a room with the outer peripheral surface of said drum (30).

8. The film deposition device according to any one of claims 1 to 7, wherein said control means (54, 70) keeps said differential room at a higher pressure by at least 5 Pa than one of said CVD film forming room (18) and said treatment room (14, 24) which has a higher pressure than the other.

9. The film deposition device according to any one of claims 1 to 8, wherein
the difference between the pressure of said differential room (16, 20) and that of one of said treatment room (14) and said CVD film forming room (18) having the higher pressure is 10 Pa or less.

10. The film deposition device according to any one of claims 1 to 9, wherein said CVD film forming room (18) is arranged to deposit a gas barrier film by plasma-enhanced CVD.

11. The film deposition device according to claim 1, comprising:
at least one CVD film forming room (18, 24) disposed on a travel path of said substrate (Z) and having a function of performing the film deposition on said substrate (Z) by CVD;
differential rooms (16, 20, 26) disposed on said travel path so that said at least one CVD film forming room (18, 24) is interposed between and communicates with said differential rooms (16, 20, 26);
at least one film deposition treatment room (18, 24) disposed on said travel path and having a function of performing the film deposition on said substrate (Z) in vacuum;
a first treatment room (14) disposed at an upstream end of said travel path and having a function of feeding said substrate from a substrate roll into which said substrate is wound; and
a second treatment room (14) disposed at a downstream end of said travel path and having a function of winding said substrate (Z) having undergone the film deposition in said at least one CVD film forming room,
wherein at least one treatment room (14) of said at least one film deposition treatment room (18, 24), said first treatment room (14) and said second treatment room (14) communicates with said differential rooms (16, 26) and is disposed so as to be adjacent to said at least one CVD film forming room (18, 24) via said differential rooms (16, 26), and
wherein each of said differential rooms (16, 26) includes an evacuation means (52, 68), a gas introducing means (50, 80) for introducing at least one of a gas to be supplied to both of said at least one CVD film forming room (18, 24) and said at least one treatment room (14) adjacent thereto, and an inert gas, and a control means (54, 84) which controls said evacuation means (52, 82) and said gas introducing means (50, 80) to keep said differential rooms (16, 26) at a higher pressure than said at least one CVD film forming room (18, 24) and said at least one treatment room (14) adjacent thereto.

12. The film deposition device according to claim 11, wherein said at least one film deposition treatment room (18, 24) is said at least one CVD film forming room (18, 24) performing the film deposition on said substrate (Z) by CVD and one of said differential rooms (20) is disposed between and communicates with adjacent two CVD film forming rooms (18, 24).

13. The film deposition device according to claim 11 or 12, wherein said film deposition device (10) comprises a plurality of CVD film forming rooms.

14. The film deposition device according to any one of claims 11 to 13, wherein said first treatment room (14) and said second treatment room (14) are unified as a feed and take-up room (14).

15. The film deposition device according to any one of claims 11 to 14, further comprising one vacuum chamber (12),
wherein said at least one CVD film forming room (18, 24), said at least one film deposition treatment room (18, 24), said first treatment room (14), said second treatment room (14) and said differential rooms (16, 20, 26) are disposed in said one vacuum chamber (12).

16. The film deposition device according to any one of claims 11 to 15, wherein said control means (54, 70, 84) controls a pressure of said differential rooms (16, 20, 26) at a higher level by at least 5 Pa than one of said at least one CVD film forming room (18, 24), said at least one film deposition treatment room (18, 24), said first treatment room (14) and said second treatment room (14) which has a highest pressure.

17. The film deposition device according to any one of claims 11 to 16, wherein the difference between the pressure of said differential room (16, 20, 26) and that of one of said treatment room (14) and said CVD film forming room (18) having the higher pressure is 10 Pa or less.

18. The film deposition device according to any one of claims 11 to 17, wherein said at least one CVD film forming room (18, 24) is arranged to deposit a gas barrier film by plasma-enhanced CVD.

## Patentansprüche

1. Eine Filmabscheidungsvorrichtung (10), bei der die Filmabscheidung auf einem länglichen Substrat (Z) durchgeführt wird, das sich in Längsrichtung bewegt, die Filmabscheidungsvorrichtung (10) umfasst:
einen auf einer Bewegungsbahn des Substrats (Z) angeordneten CVD Filmbildungsraum (18), der eine Materialgaszuführeinrichtung (58), eine erste Evakuierungseinrichtung (62) und eine Funktion zur Durchführung der Filmabscheidung auf dem Substrat (Z) durch CVD aufweist;
einen Behandlungsraum (14, 24), der flussaufwärts oder flussabwärts des CVD Filmbildungsraums (18) auf der Bewegungsbahn angeordnet ist, und eine zweite Evakuierungseinrichtung (46, 78) und eine Funktion zur Durchführung einer vorbestimmten Behandlung auf dem Substrat (Z) aufweist;
einen Differentialraum (16, 20), der zwischen dem CVD Filmbildungsraum (18) und dem Behandlungsraum (14, 24) auf der Bewegungsbahn angeordnet ist und mit diesen in Verbindung steht;
und eine Trommel (30) auf einer äußeren Umfangsfläche, auf der sich das Substrat (Z) bewegt, und wobei der CVD Filmbildungsraum (18, 24), der Filmabscheidungsbehandlungsraum (18, 24) und der Differenzialraum (16, 20, 26) einen Raum mit der äußeren Umfangsfläche der Trommel (30) bilden,
wobei die Trommel (30) als eine Gegenelektrode einer Duschkopfelektrode (56) in dem CVD Filmbildungsraum (18) dient,
wobei der Differenzialraum (16, 20) eine dritte Evakuierungseinrichtung (52, 68), eine Gaszuführeinrichtung (50, 64) zur Zuführung von mindestens einem Gas, das sowohl in den CVD Filmbildungsraum (18) und in den Behandlungsraum (14, 24) zugeführt wird, und ein Inertgas aufweist, wobei der Differentialraum (16, 20) eine Steuereinrichtung (54, 70) aufweist, die die dritte Evakuierungseinrichtung (52, 68) und die Gaszuführeinrichtung (50, 64) steuert, um den Differentialraum (16, 20) auf einem höheren Druck als der CVD Filmbildungsraum (18) und der Behandlungsraum (14, 24) zu halten.

2. Die Filmabscheidungsvorrichtung nach Anspruch 1, wobei die Filmabscheidung auf dem Substrat (Z) im Vakuum als die vorbestimmte Behandlung in dem Behandlungsraum (24) durchgeführt wird.

3. Die Filmabscheidungsvorrichtung nach Anspruch 2, wobei die Filmabscheidung auf dem Substrat (Z) durch CVD als die vorbestimmte Behandlung in dem Behandlungsraum (24) durchgeführt wird.

4. Die Filmabscheidungsvorrichtung nach einem der Ansprüche 1 bis 3, wobei in dem Behandlungsraum (14) als die vorbestimmte Behandlung mindestens eine Zufuhr des Substrats (Z) von einer Substratrolle (32), in die das Substrat (Z) gewickelt ist, und die Aufnahme des Substrats (Z), das der Filmabscheidung in dem CVD Filmbildungsraum (18) unterzogen wurde, durchgeführt ist.

5. Die Filmabscheidungsvorrichtung nach einem der Ansprüche 1 bis 4, ferner einen Vakuumkammer (12) umfasst,
wobei der CVD-Filmbildungsraum (18), der Behandlungsraum (14, 24) und der Differentialraum (16, 20) in dem Vakuumkammer (12) angeordnet sind.

6. Die Filmabscheidungsvorrichtung nach einem der Ansprüche 1 bis 5, wobei die Filmabscheidungsvorrichtung (10) eine Trommel (30) aufweist, auf einer äußeren Umfangsfläche von welcher sich das Substrat (Z) bewegt, und wobei mindestens einer von dem CVD Filmbildungsraum (18), dem Behandlungsraum (14, 24) und dem Differenzialraum (16, 20) einen Raum mit der äußeren Umfangsfläche der Trommel (30) bildet.

7. Die Filmabscheidungsvorrichtung nach Anspruch 6, wobei jeder von dem CVD Filmbildungsraum (18), dem Behandlungsraum (14, 24) und dem Differenzialraum (16, 20) einen Raum mit der äußeren Umfangsfläche der Trommel (30) bildet.

8. Die Filmabscheidungsvorrichtung nach einem der Ansprüche 1 bis 7, wobei die Steuereinrichtung (54, 70) den Differenzialraum bei einem höheren Druck um mindestens 5 Pa hält als einer von dem CVD Filmbildungsraums (18) und dem Behandlungsraums (14, 24), der einen höheren Druck als der andere aufweist.

9. Die Filmabscheidungsvorrichtung nach einem der Ansprüche 1 bis 8, wobei
der Unterschied zwischen dem Druck des Differenzialraums (16, 20) und dem des Behandlungsraums (14) und des CVD-Filmbildungsraumes (18) mit dem höheren Druck 10 Pa oder weniger beträgt.

10. Die Filmabscheidungsvorrichtung nach einem der Ansprüche 1 bis 9, wobei der CVD Filmbildungsraum (18) so angeordnet ist, dass er einen Gassperrfilm durch plasmaverstärkte CVD abscheidet.

11. Die Filmabscheidungsvorrichtung nach Anspruch 1, umfassend,
mindestens einen CVD Filmbildungsraum (18, 24), der auf einer Bewegungsbahn des Substrats (Z) angeordnet ist und eine Funktion zur Durchführung der Filmabscheidung auf dem Substrat (Z) durch CVD aufweist;
die Differentialräume (16, 20, 26), die auf einer Bewegungsbahn angeordnet sind, so dass mindestens ein CVD Filmbildungsraum (18, 24) zwischen den Differentialräumen (16, 20, 26) angeordnet ist und mit diesen in Verbindung steht;
mindestens einen Filmabscheidungsbehandlungsraum (18, 24), der auf der Bewegungsbahn angeordnet ist und eine Funktion zur Durchführung der Filmabscheidung auf dem Substrat (Z) im Vakuum aufweist;
einen ersten Behandlungsraum (14), der an einem Flussaufwärtsende der Bewegungsbahn angeordnet ist und eine Funktion zur Zuführung des Substrats von einer Substratrolle aufweist, in die das Substrat gewickelt ist; und
einen zweiten Behandlungsraum (14), der an einem Flussabwärtsende der Bewegungsbahn angeordnet ist und eine Funktion zum Aufwickeln des Substrats (Z) aufweist, das der Filmabscheidung in dem mindestens einen CVD Filmbildungsraum unterzogen wurde,
wobei mindestens ein Behandlungsraum (14) des mindestens einen Filmabscheidungssbehandlungsraums (18, 24), des ersten Behandlungsraums (14) und des zweiten Behandlungsraum (14) mit den Differentialräumen (16, 26) in Verbindung steht, an dem mindestens einen CVD Filmbildungsraum (18, 24) über die Differentialräume (16, 26) angegrenzt ist, und
wobei jeder der Differentialräume (16, 26) eine Evakuierungseinrichtung (52, 68), eine Gaszuführeinrichtung (50, 80) zur Zuführung von mindestens einem Gas, das sowohl in den mindestens einen CVD Filmbildungsraum (18, 24) und daran angrenzenden Behandlungsraum (14) zugeführt wird, und ein Inertgas und eine Steuereinrichtung (54, 84) aufweist, die die Evakuierungseinrichtung (52, 82) und die Gaszuführeinrichtung (50, 80) steuert, um die Differentialräume (16, 26) auf einem höheren Druck als der mindestens eine CVD Filmbildungsraum (18, 24) und der mindestens eine daran angrenzenden Behandlungsraum (14) zu halten.

12. Die Filmabscheidungsvorrichtung nach Anspruch 11,
wobei mindestens ein Filmabscheidungsbehandlungsraum (18, 24) mindestens ein CVD Filmbildungsraum (18, 24) ist, der die Filmabscheidung auf dem Substrat (Z) durch CVD durchführt und einer der Differenzräume (20) zwischen benachbarten zwei CVD Filmbildungsräumen (18, 24) angeordnet ist und mit diesen in Verbindung steht.

13. Die Filmabscheidungsvorrichtung nach Anspruch 11 oder 12, wobei die Filmabscheidungsvorrichtung (10) eine Vielzahl von CVD Filmbildungsräumen umfasst.

14. Die Filmabscheidungsvorrichtung nach einem der Ansprüche 11 bis 13, wobei der erste Behandlungsraum (14) und der zweite Behandlungsraum (14) als Zuführ- und Aufnahmeraum (14) vereinheitlicht sind.

15. Die Filmabscheidungsvorrichtung nach einem der Ansprüche 11 bis 14, ferner umfasst einen Vakuumkammer (12),
wobei mindestens ein CVD Filmbildungsraum (18, 24), mindestens ein Filmabscheidungsbehandlungsraum (18, 24), der erste Behandlungsraum (14), der zweite Behandlungsraum (14) und die Differenzialräume (16, 20, 26) in dem einen Vakuumkammer (12) angeordnet sind.

16. Die Filmabscheidungsvorrichtung nach einem der Ansprüche 11 bis 15, wobei die Steuereinrichtung (54, 70, 84) einen Druck der Differenzialräume (16, 20, 26) auf einem höheren Niveau um mindestens 5 Pa steuert, als einer von dem mindestens einen CVD Filmbildungsraum (18, 24), dem mindestens einen Filmabscheidungsbehandlungsraum (18, 24), dem ersten Behandlungsraum (14) und dem zweiten Behandlungsraum (14), der den höchsten Druck hat.

17. Die Filmabscheidungsvorrichtung nach einem der Ansprüche 11 bis 16, wobei der Unterschied zwischen dem Druck des Differenzialraums (16, 20, 26) und dem von dem Behandlungsraum (14) und dem CVD Filmbildungsraum (18), der den höheren Druck aufweist, 10 Pa oder weniger beträgt.

18. Die Filmabscheidungsvorrichtung nach einem der Ansprüche 11 bis 17, wobei mindestens ein CVD Filmbildungsraum (18, 24) angeordnet ist, um einen Gassperrfilm durch plasmaverstärkte CVD abzuscheiden.

## Revendications

1. Dispositif de dépôt de film (10) dans lequel un dépôt de film est réalisé sur un substrat allongé (Z) qui se déplace dans une direction longitudinale, le dispositif de dépôt de film (10) comprenant :
une chambre de formation de film par CVD (18) disposée sur un trajet de déplacement dudit substrat (Z), incluant un moyen d'alimentation en matériau gazeux (58) et un premier moyen d'évacuation (62) et ayant une fonction de réalisation du dépôt de film sur ledit substrat (Z) par CVD ;
une chambre de traitement (14, 24) disposée en amont ou en aval de ladite chambre de formation de film par CVD (18) sur le trajet de déplacement, incluant un deuxième moyen d'évacuation (46, 78) et ayant une fonction de réalisation d'un traitement prédéterminé sur ledit substrat (Z);
une chambre différentielle (16, 20) disposée entre et communiquant avec ladite chambre de formation de film par CVD (18) et ladite chambre de traitement (14, 24) sur ledit trajet de déplacement;
et un tambour (30) sur une surface périphérique extérieure duquel ledit substrat (Z) se déplace, et dans lequel ladite chambre de formation de film par CVD (18, 24), ladite chambre de traitement de dépôt de film (18, 24) et ladite chambre différentielle (16, 20, 26) forment une chambre avec la surface périphérique extérieure dudit tambour (30),
dans lequel ledit tambour (30) sert de contre-électrode d'une électrode en pomme de douche (56) dans ladite chambre de formation de film par CVD (18),
dans lequel ladite chambre différentielle (16, 20) inclut un troisième moyen d'évacuation (52, 68), un moyen d'introduction de gaz (50, 64) pour introduire au moins un gaz parmi un gaz devant être fourni à la fois à ladite chambre de formation de film par CVD (18) et à ladite chambre de traitement (14, 24), et un gaz inerte, dans lequel ladite chambre différentielle (16, 20) comprend un moyen de commande (54, 70) qui commande ledit troisième moyen d'évacuation (52, 68) et ledit moyen d'introduction de gaz (50, 64) pour maintenir ladite chambre différentielle (16, 20) à une pression plus élevée que ladite chambre de formation de film par CVD (18) et ladite chambre de traitement (14, 24).

2. Dispositif de dépôt de film selon la revendication 1, dans lequel le dépôt de film est réalisé sur ledit substrat (Z) sous vide en tant que dit traitement prédéterminé dans ladite chambre de traitement (24).

3. Dispositif de dépôt de film selon la revendication 2, dans lequel le dépôt de film est réalisé sur ledit substrat (Z) par CVD en tant que dit traitement prédéterminé dans ladite chambre de traitement (24).

4. Dispositif de dépôt de film selon l'une quelconque des revendications 1 à 3, dans lequel, dans ladite chambre de traitement (14) en tant que dit traitement prédéterminé, au moins l'une parmi l'alimentation dudit substrat (Z) à partir d'un rouleau de substrat (32) dans lequel ledit substrat (Z) est enroulé et la réception dudit substrat (Z) ayant subi le dépôt de film dans ladite chambre de formation de film par CVD (18) est effectuée.

5. Dispositif de dépôt de film selon l'une quelconque des revendications 1 à 4, comprenant en outre une chambre à vide (12),
dans lequel ladite chambre de formation de film par CVD (18), ladite chambre de traitement (14, 24) et ladite chambre différentielle (16, 20) sont disposées dans ladite chambre à vide (12).

6. Dispositif de dépôt de film selon l'une quelconque des revendications 1 à 5, dans lequel ledit dispositif de dépôt de film (10) inclut un tambour (30) sur une surface périphérique extérieure duquel ledit substrat (Z) se déplace, et dans lequel au moins l'une parmi ladite chambre de formation de film par CVD (18), ladite chambre de traitement (14, 24) et ladite chambre différentielle (16, 20) forme une chambre avec la surface périphérique extérieure dudit tambour (30).

7. Dispositif de dépôt de film selon la revendication 6, dans lequel chacune desdites chambre de formation de film par CVD (18), chambre de traitement (14, 24) et chambre différentielle (16, 20) forme une chambre avec la surface périphérique extérieure dudittambour (30).

8. Dispositif de dépôt de film selon l'une quelconque des revendications 1 à 7, dans lequel ledit moyen de commande (54, 70) maintient ladite chambre différentielle à une pression plus élevée d'au moins 5 Pa que l'une desdites chambre de formation de film par CVD (18) et chambre de traitement (14, 24) qui a une pression plus élevée que l'autre.

9. Dispositif de dépôt de film selon l'une quelconque des revendications 1 à 8, dans lequel
la différence entre la pression de ladite chambre différentielle (16, 20) et de l'une de celles desdites chambre de traitement (14) et chambre de formation de film par CVD (18) ayant la pression plus élevée est de 10 Pa ou moins.

10. Dispositif de dépôt de film selon l'une quelconque des revendications 1 à 9, dans lequel ladite chambre de formation de film par CVD (18) est agencée pour déposer un film formant barrière aux gaz par CVD activé par plasma.

11. Dispositif de dépôt de film selon la revendication 1, comprenant :
au moins une chambre de formation de film par CVD (18, 24) disposée sur un trajet de déplacement dudit substrat (Z) et ayant une fonction de réalisation du dépôt de film sur ledit substrat (Z) par CVD ;
des chambres différentielles (16, 20, 26) disposées sur ledit trajet de manière à ce que ladite au moins une chambre de formation de film par CVD (18, 24) est interposée entre et communique avec lesdites chambres différentielles (16, 20, 26) ;
au moins une chambre de traitement par dépôt de film (18, 24) disposée sur ledit trajet de déplacement et ayant une fonction de réalisation du dépôt de film sur ledit substrat (Z) sous vide ;
une première chambre de traitement (14) disposée à une extrémité amont dudit trajet de déplacement et ayant une fonction d'alimentation dudit substrat à partir d'un rouleau de substrat dans lequel ledit substrat est enroulé; et
une seconde chambre de traitement (14) disposée à une extrémité aval dudit trajet de déplacement et ayant une fonction d'enroulement dudit substrat (Z) ayant subi le dépôt de film dans ladite au moins une chambre de formation de film par CVD,
dans lequel au moins une chambre de traitement (14) parmi ladite au moins une chambre de traitement par dépôt de film (18, 24), ladite première chambre de traitement (14) et ladite seconde chambre de traitement (14) communique avec lesdites chambres différentielles (16, 26) et est disposée de façon à être adjacente à ladite au moins une chambre de formation de film par CVD (18, 24) par l'intermédiaire desdites chambres différentielles (16, 26), et
dans lequel chacune desdites chambres différentielles (16, 26) inclut un moyen d'évacuation (52, 68), un moyen d'introduction de gaz (50, 80) pour introduire au moins un gaz parmi un gaz devant être fourni aux deux chambres parmi ladite au moins une chambre de formation de film par CVD (18, 24) et ladite au moins une chambre de traitement (14) qui lui est adjacente, et un gaz inerte, et un moyen de commande (54, 84) qui commande ledit moyen d'évacuation (52, 82) et ledit moyen d'introduction de gaz (50, 80) pour maintenir lesdites chambres différentielles (16, 26) à une pression plus élevée que ladite au moins une chambre de formation de film par CVD (18, 24) et ladite au moins une chambre de traitement (14) adjacente à celle-ci.

12. Dispositif de dépôt de film selon la revendication 11, dans lequel ladite au moins une chambre de traitement par dépôt de film (18, 24) constitue ladite au moins une chambre de formation de film par CVD (18, 24) réalisant le dépôt de film sur ledit substrat (Z) par CVD et l'une desdites chambres différentielles (20) est disposée entre et communique avec deux chambres de formation de film par CVD adjacentes (18, 24).

13. Dispositif de dépôt de film selon la revendication 11 ou 12, dans lequel ledit dispositif de dépôt de film (10) comprend une pluralité de chambres de formation de film par CVD.

14. Dispositif de dépôt de film selon l'une quelconque des revendications 11 à 13, dans lequel ladite première chambre de traitement (14) et ladite seconde chambre de traitement (14) sont unifiées en tant que chambre d'alimentation et de réception (14).

15. Dispositif de dépôt de film selon l'une quelconque des revendications 11 à 14, comprenant en outre une chambre à vide particulière (12),
dans lequel ladite au moins une chambre de formation de film par CVD (18, 24), ladite au moins une chambre de traitement par dépôt de film (18, 24), ladite première chambre de traitement (14), ladite seconde chambre de traitement (14) et lesdites chambres différentielles (16, 20, 26) sont disposées dans ladite chambre à vide particulière (12).

16. Dispositif de dépôt de film selon l'une quelconque des revendications 11 à 15, dans lequel ledit moyen de commande (54, 70, 84) commande une pression desdites chambres différentielles (16, 20, 26) à un niveau supérieur d'au moins 5 Pa à ladite au moins une chambre de traitement par dépôt de film par CVD (18, 24), ladite au moins une chambre de traitement par dépôt de film (18, 24), ladite première chambre de traitement (14) et ladite seconde chambre de traitement (14) qui présente une pression la plus élevée.

17. Dispositif de dépôt de film selon l'une quelconque des revendications 11 à à 16, dans lequel la différence entre la pression de ladite chambre différentielle (16, 20, 26) et l'une de celles parmi ladite chambre de traitement (14) et ladite chambre de formation de film par CVD (18) ayant la pression plus élevée est de 10 Pa ou moins.

18. Dispositif de dépôt de film selon l'une quelconque des revendications 11 à 17, dans lequel ladite au moins une chambre de formation de film par CVD (18, 24) est agencée pour déposer un film formant barrière aux gaz par CVD activé par plasma.
